# EUROPEAN PATENT SPECIFICATION

(11) **EP 2 802 197 B1**
(45) Date of publication and mention of the grant of the patent: **14.02.2018**
(21) Application number: 12871828.5
(22) Date of filing: 05.12.2012
(51) Int. Cl.: H05K 7/20

(54) **ELECTRONIC DEVICE AS WELL AS HEAT RADIATING SYSTEM AND HEAT RADIATING METHOD THEREOF**
ELEKTRONISCHE VORRICHTUNG SOWIE WÄRMESTRAHLUNGSSYSTEM UND WÄRMESTRAHLUNGSVERFAHREN DAFÜR
DISPOSITIF ÉLECTRONIQUE, SYSTÈME DE RAYONNEMENT DE CHALEUR ET SON PROCÉDÉ DE RAYONNEMENT DE CHALEUR

(30) Priority: 21.03.2012 CN 201210076472
(43) Date of publication of application: 12.11.2014
(73) Proprietor: Huawei Technologies Co., Ltd., Longgang District Shenzhen, Guangdong 518129 (CN)
(72) Inventor: HUANG, Shuliang, Shenzhen Guangdong 518129 (CN); LUO, Zhaoxia, Shenzhen Guangdong 518129 (CN); KE, Youhe, Shenzhen Guangdong 518129 (CN)
(74) Representative: Maiwald Patentanwalts GmbH
(86) International application number: PCT/CN2012/085944
(87) International publication number: WO 2013/139144

(56) References cited:
- WO-A1-2008/055515
- CN-A- 102 037 426
- CN-A- 102 625 639
- JP-A- H04 170 097
- US-B2- 7 012 807
- US-B2- 7 274 566
- COUNCILL E D ET AL: "TEMPERATURE-CONTROLLED IMMERSED COOLING SYSTEM", IBM TECHNICAL DISCLOSURE BULLETIN,, vol. 11, no. 9, 1 February 1969 (1969-02-01), pages 1097-1098, XP001450259,

## Description

### TECHNICAL FIELD

The present invention belongs to the field of heat dissipation technologies, and in particular, to an electronic device and a heat dissipation system and heat dissipation method of an electronic device.

### BACKGROUND

Currently, heat dissipation is generally performed for an electronic device, such as a blade server, in an air-cooled or liquid-cooled manner. In an existing liquid-cooled heat dissipation system, an electronic device, such as a blade server, is generally immersed in a cooling medium, and the cooling medium is brought, by circulation, out of a cabinet for cooling and flowing back, so as to dissipate heat for the electronic device in the cabinet.

In the foregoing process, the prior art has the following disadvantages: A cooling medium is an insulating heat conducting liquid. However, currently, pure water or another working medium is generally used for a common refrigerating water machine or another cooling apparatus, and the cooling medium is not supported. A heat exchange/refrigerating device supporting the cooling medium needs to be separately customized or purchased, thereby causing an additional investment cost.

JP H04 170097 A describes a cooling mechanism for dissipating heat. A sealed container is filled up with coolant being cooled by a heat exchanger and heat sources are located within the coolant. Fans are provided to circulate the coolant in the container.

Council E. D. et al.: "Temperature-controlled immersed cooling system, IBM Technical disclosure Bulletin, vol. 11, no. 9 describes an electronic package immersed in a container comprising a dielectric cooling fluid. The electronic package comprises a central array and a plurality of cards carrying heat generating electronic components. A heat exchanger is provided in the cooling fluid in order to enable a heat transfer from the electronic modules.

### SUMMARY

A technical issue that the present invention needs to address is to provide an electronic device and a heat dissipation system and heat dissipation method of an electronic device, which can be used in combination with a common heat exchange/refrigerating device, without a need of separate customization or purchase, thereby reducing an investment cost.

To achieve the foregoing objective, the following technical solutions are used in embodiments of the present invention:
A heat dissipation system of an electronic device includes a cooling pool, a heat exchanger, and at least one circulating pump, where:
   a cooling medium is provided in the cooling pool, and the electronic device and the heat exchanger are immersed in the cooling medium;
   the circulating pump is configured to drive the cooling medium to circulatively flow between the electronic device and the heat exchanger; and a heat exchange medium is provided in the heat exchanger and used to exchange heat with the cooling medium, and the heat exchange medium flows out of the heat exchanger for cooling and then flows back;
   a spacer plate, configured to divide the cooling pool into two runners, wherein the cooling medium flows from the electronic device to the heat exchanger in one of the runners, and flows from the heat exchanger to the electronic device in the other runner;
   the heat cxchangcr is a liquid-to-liquid heat cxchangcr.

An embodiment of the present invention further provides an electronic device, which is disposed with a heat dissipation system provided in an embodiment of the present invention.

According to the electronic device and the heat dissipation system provided in the embodiments of the present invention, a cooling medium circulatively flows between an electronic device and a heat exchanger, heat released by the electronic device is transferred to a heat exchange medium in the heat exchanger by flowing of the cooling medium, and after absorbing the heat, the heat exchange medium flows out for cooling and then flows back, so as to discharge the heat released by the electronic device. A common heat exchange/refrigerating device, such as a refrigerating water machine, may be used when the heat exchange medium undergoes cooling outside, without a need of separately customizing or purchasing a heat exchange/refrigerating device supporting the cooling medium, thereby reducing an investment cost.

### BRIEF DESCRIPTION OF DRAWINGS

To describe the technical solutions in the embodiments of the present invention or in the prior art more clearly, the following briefly introduces the accompanying drawings required for describing the embodiments or the prior art. Apparently, the accompanying drawings in the following description show merely some embodiments of the present invention, and a person of ordinary skill in the art may still derive other drawings from these accompanying drawings without creative efforts.
FIG. 1 is a first schematic structural diagram of a heat dissipation system according to an Embodiment 1 of the present invention;
FIG. 2 is a schematic structural diagram of a liquid-to-liquid heat exchanger according to an Embodiment 1 of the present invention;
FIG. 3 is a second schematic structural diagram of a heat dissipation system according to an Embodiment 1 of the present invention;
FIG. 4 is a third schematic structural diagram of a heat dissipation system according to an Embodiment 1 of the present invention; and
FIG. 5 is a flowchart of a heat dissipation method for better understanding the invention.

Reference numeral in the accompanying drawings are described as follows:
11 - Cooling pool, 12 - Heat exchanger, 13 - Circulating pump, 14 - Electronic device, 15 - Spacer plate,
16 - Cooling apparatus, 111 - Cooling medium, 121 - Heat sink, and 122 - Pipe interface

### DESCRIPTION OF EMBODIMENTS

The following clearly and completely describes the technical solutions in the embodiments of the present invention with reference to the accompanying drawings in the embodiments of the present invention.

The embodiments of the present invention provide an electronic device and a heat dissipation system, which can be used in combination with a common heat exchange/refrigerating device, without a need of separate customization or purchase, thereby reducing an investment cost.

### Embodiment 1

The electronic device provided in the embodiments of the present invention may be a blade server or the like, which is not limited in the embodiments of the present invention.

### Embodiment 1

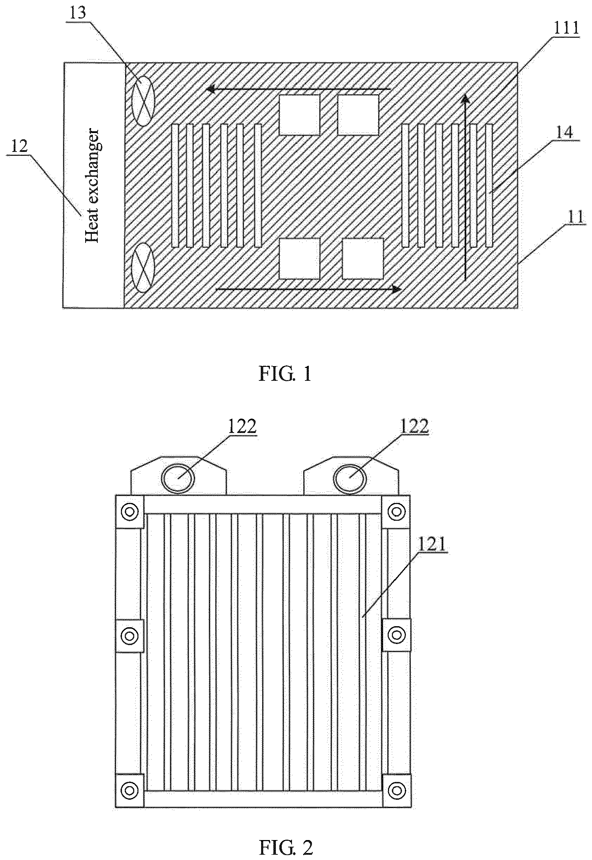

As shown in FIG. 1, an embodiment of the present invention provides a heat dissipation system of an electronic device, including a cooling pool 11, a heat exchanger 12, and at least one circulating pump 13, where:
a cooling medium 111 is provided in the cooling pool 11, and an electronic device 14 and the heat exchanger 12 are immersed in the cooling medium 111;
the circulating pump 13 is configured to drive the cooling medium 111 to circulatively flow between the electronic device 14 and the heat exchanger 13, where a direction indicated by an arrow in FIG. 1 is a direction in which the cooling medium 111 flows in the cooling pool 11; and
a heat exchange medium is provided in the heat exchanger 13 and used to exchange heat with the cooling medium 111, and the heat exchange medium flows out of the heat exchanger 13 for cooling and then flows back, so as to
discharge heat released by the electronic device 14.

In this embodiment, the electronic device 14 is immersed in the cooling medium 111, which may be understood as that components forming the electronic device 14 are immersed in the cooling medium 111. Optionally, a cabinet used to hold the electronic device 14 is filled with the cooling medium 111, thereby forming the cooling pool 11, and the components of the electronic device 14 and the heat exchanger 12 are immersed in the cooling medium 111.

As shown in FIG. 1, the heat exchanger 12 is disposed on a left side of the cooling pool 11, the cooling medium 111 performs heat exchange in the area, and transfers heat released by the electronic device 14 to the heat exchange medium in the heat exchanger 12 by flowing of the cooling medium 111, and the heat exchange medium brings the heat out, so as to discharge the heat.

In this embodiment, the cooling medium 111 is an insulating heat conducting liquid, the cooling medium 111 circulatively flows between the electronic device 14 and the heat exchanger 12, and transfers the heat released by the electronic device 14 to the heat exchange medium in the heat exchanger 12 by the flowing of the cooling medium 111, and after absorbing the heat, the heat exchange medium flows out of the cooling pool 11 for cooling and then flows back. A common heat exchange/refrigerating device, such as a refrigerating water machine, may be used when the heat exchange medium undergoes cooling outside, without a need of separately customizing or purchasing a heat exchange/refrigerating device supporting the cooling medium, thereby reducing an investment cost.

In this embodiment, natural convection is not used for the cooling medium 111; instead, the circulating pump 13 is used to drive the cooling medium 111 to circulatively flow in the cooling pool 11 and transfer the heat released by the electronic device 14 to the heat exchange medium in the heat exchanger 12. Therefore, in this embodiment, a position of the heat exchanger 12 can be flexibly arranged and is not limited to an upper side of the electronic device 14, thereby saving height space and reducing a requirement for a height limit on the components of the electronic device 14. Optionally, the heat exchanger 12 is disposed on one side of the cooling pool 11. As shown in FIG. 1, the heat exchanger 12 is disposed on the left side of the cooling pool 11. In this embodiment, a position and a quantity of the circulating pump 13 may also be adjusted according to an actual requirement.

In this embodiment, other than the position of the heat exchanger 12, positions of the components of the electronic device 14 can also be flexibly arranged. Therefore, according to the heat dissipation system provided in this embodiment, structural optimization design can be performed, according to a specific condition, on an entire device including the electronic device and the heat dissipation system, so as to save space and reduce a floor area of the device. In addition, in this embodiment, the circulating pump 13 provides a driving force for the cooling medium 111 to flow in a direction, and flowing of the cooling medium improves heat dissipation efficiency of the components of the electronic device 14.

Optionally, in this embodiment, the heat exchanger is a liquid-to-liquid heat exchanger. A specific structure of a liquid-to-liquid heat exchanger varies. FIG. 2 shows a specific structure of a liquid-to-liquid heat exchanger. The liquid-to-liquid heat exchanger includes several heat sinks 121, and a passing channel for the heat exchange medium is provided in each heat sink. A pipe interface 122 is further provided in the liquid-to-liquid heat exchanger for the heat exchange medium to pass through, and includes a liquid inlet and a liquid outlet. The heat exchange medium flows out of the heat exchanger from the liquid outlet, undergoes cooling, and then flows back into the heat exchanger from the liquid inlet. The heat released by the electronic device is transferred to the heat exchanger by the flowing of the cooling medium. When the cooling medium flows through a gap between the heat sinks 121, the cooling medium exchanges heat with the heat exchange medium in the heat exchanger, and the heat exchange medium brings the heat out.

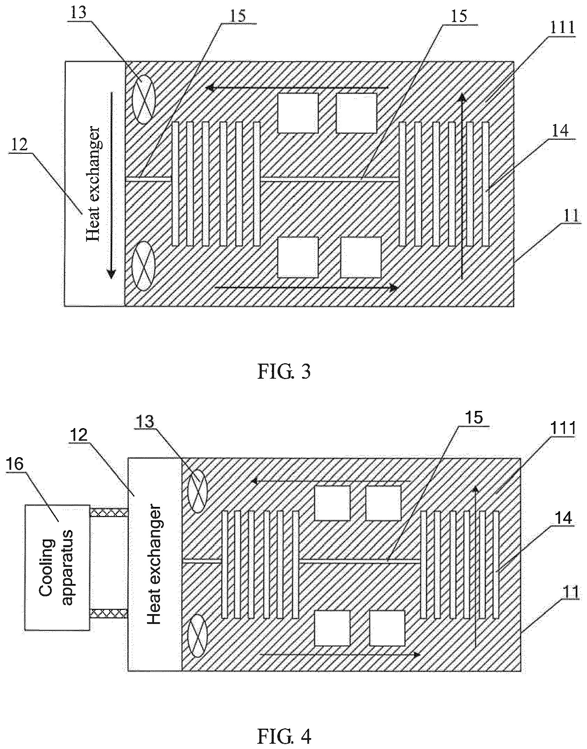

Optionally, as shown in FIG. 3, the heat dissipation system provided in this embodiment may further include a spacer plate 15 which is used to divide the cooling pool 11 into two runners. As indicated by an arrow in FIG. 3, the cooling medium 111 flows from the electronic device 14 to the heat exchanger 12 in one of the runners, and flows from the heat exchanger 12 to the electronic device 14 in the other runner. The cooling pool is divided into two runners by using the spacer plate, thereby preventing a low temperature cooling medium that flows out of the heat exchanger from mixing with a high temperature cooling medium that is to flow into the heat exchanger, so that the heat flows with the cooling medium in order and the cooling medium transfers the heat released by the electronic device to the heat exchange medium, thus improving heat dissipation efficiency.

Further, as shown in FIG. 4, the heat dissipation system further includes a cooling apparatus 16 disposed outside the cooling pool 11, where the heat exchanger 12 is connected to the cooling apparatus 16 by using a pipe, and the heat exchange medium in the heat exchanger 12 flows out of the heat exchanger 12, undergoes cooling by the cooling apparatus 16, and then flows back. Optionally, the cooling apparatus 16 may also be replaced with a refrigerating water machine, and the heat exchange medium is water. The heat exchanger is connected to a common cooling apparatus or refrigerating water machine, without a need of separately customizing or purchasing a heat exchange/refrigerating device, thereby reducing an investment cost.

The heat dissipation system provided in the embodiment of the present invention can be used in combination with a common heat exchange/refrigerating device, without a need of separate customization or purchase, thereby reducing an investment cost. A circulating pump is used to drive a cooling medium to circulatively flow in a cooling pool, so as to help improve heat dissipation efficiency. In addition, a position of a heat exchanger and a position of an electronic device can be flexibly arranged in the cooling pool, so as to save space and reduce a floor area.

An embodiment of the present invention further provides an electronic device which is disposed with any one heat dissipation system provided in the embodiments of the present invention.

A liquid cooled heat dissipation system is adopted by the electronic device provided in the embodiment of the present invention. The heat dissipation system provides high heat dissipation efficiency and can be used in combination with a common heat exchange/refrigerating device, thereby reducing an investment cost.

### Example

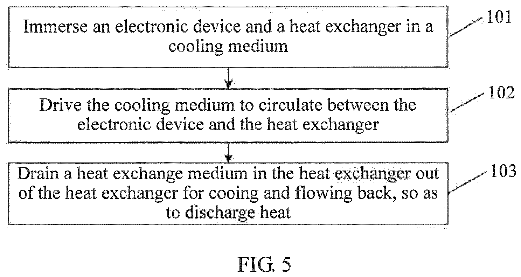

An example for understanding the invention provides a heat dissipation method of an electronic device, as shown in FIG. 5, including:
Step 101: Immerse the electronic device and a heat exchanger in a cooling medium, where a heat exchange medium is provided in the heat exchanger, so as to exchange heat with the cooling medium.
Step 102: Drive the cooling medium to circulatively flow between the electronic device and the heat exchanger. Optionally, use a circulating pump to drive the cooling medium to flow, where a position and a quantity of the circulating pump may be adjusted according to a requirement.
Step 103: Drain the heat exchange medium in the heat exchanger out of the heat exchanger for cooing and flowing back, so as to discharge heat released by the electronic device.

The heat dissipation method provided in the embodiment of the present invention can be used in combination with a common heat exchange/refrigerating device, thereby reducing an investment cost. A cooling medium is driven to circulatively flow in a cooling pool, so as to help improve heat dissipation efficiency. In addition, a position of a heat exchanger and a position of an electronic device can be flexibly arranged in the cooling pool, thereby achieving objectives of optimizing structural design, saving space, and reducing a floor area.

Optionally, the heat exchanger is a liquid-to-liquid heat exchanger.

Optionally, the heat exchanger is disposed on one side of the cooling pool.

Further, step 103 of the heat dissipation method provided in the embodiment of the present invention is specifically:
Drain the heat exchange medium out of the heat exchanger for cooling by a cooling apparatus or a refrigerating water machine and flowing back, where the cooling apparatus or the refrigerating water machine is disposed outside the cooling pool and connected to the heat exchanger by using a pipe.

The heat dissipation method provided in the example can be used with a common heat exchange/refrigerating device, thereby reducing an investment cost. According to the heat dissipation method provided in this example, heat dissipation efficiency is high, and a position of a heat exchanger and a position of an electronic device can be flexibly arranged in a cooling pool, thereby achieving objectives of optimizing structural design, saving space, and reducing a floor area.

The foregoing descriptions are merely specific implementation manners of the present invention, but are not intended to limit the protection scope of the present invention. The protection scope of the present invention shall be subject to the protection scope of the claims.

## Claims

1. A heat dissipation system of an electronic device (14), comprising a cooling pool (11), a heat exchanger (12), and at least one circulating pump (13), wherein:
a cooling medium (111) is provided in the cooling pool (11), and the electronic device (14) and the heat exchanger (12) are immersed in the cooling medium (111);
the circulating pump (13) is configured to drive the cooling medium (111) to circulatively flow between the electronic device (14) and the heat exchanger (12); and
a heat exchange medium is provided in the heat exchanger (12) and used to exchange heat with the cooling medium (111), and the heat exchange medium flows out of the heat exchanger (12) for cooling and then flows back;
a spacer plate (15), configured to divide the cooling pool (11) into two runners, wherein the cooling medium (111) flows from the electronic device (14) to the heat exchanger (12) in one of the runners, and flows from the heat exchanger (12) to the electronic device (14) in the other runner
**characterized in that**
the heat exchanger (12) is a liquid-to-liquid heat exchanger.

2. The heat dissipation system according to claim 1, wherein:
the heat exchanger (12) is disposed on one side of the cooling pool (11).

3. The heat dissipation system according to any one of claims 1 to 2, further comprising a cooling apparatus (16) or a refrigerating water machine disposed outside the cooling pool (11), wherein the heat exchanger (12) is connected to the cooling apparatus (16) or the refrigerating water machine by using a pipe, and the heat exchange medium in the heat exchanger (12) flows out of the heat exchanger (12), undergoes cooling by the cooling apparatus (16) or the refrigerating water machine, and then flows back.

4. An electronic device (14), wherein the electronic device is disposed with the heat dissipation system according to any one of claims 1 to 3.

## Patentansprüche

1. Wärmeableitungssystem einer elektronischen Vorrichtung (14), das ein Kühlbecken (11), einen Wärmetauscher (12) und wenigstens eine Umwälzpumpe (13) umfasst, wobei:
ein Kühlmedium (111) in dem Kühlbecken (11) bereitgestellt ist und die elektronische Vorrichtung (14) und der Wärmetauscher (12) in das Kühlmedium (111) eingetaucht sind;
die Umwälzpumpe (13) konfiguriert ist, das Kühlmedium (111) anzutreiben, um zwischen der elektronischen Vorrichtung (14) und dem Wärmetauscher (12) zirkulierend zu fließen; und
ein Wärmetauschmedium in dem Wärmetauscher (12) bereitgestellt ist und verwendet wird, um Wärme mit dem Kühlmedium (111) auszutauschen, und wobei das Wärmetauschmedium zum Kühlen aus dem Wärmetauscher (12) herausfließt und dann zurückfließt;
eine Distanzplatte (15), die konfiguriert ist, das Kühlbecken (11) in zwei Fließkanäle zu unterteilen, wobei das Kühlmedium (111) von der elektronischen Vorrichtung (14) zu dem Wärmetauscher (12) in einem der Fließkanäle fließt und von dem Wärmetauscher (12) zu der elektronischen Vorrichtung (14) in dem anderen Fließkanal fließt,
**dadurch gekennzeichnet, dass**
der Wärmetauscher (12) ein Flüssigkeits/Flüssigkeits-Wärmetauscher ist.

2. Wärmeableitungssystem nach Anspruch 1, wobei:
der Wärmetauscher (12) auf einer Seite des Kühlbeckens (11) angeordnet ist.

3. Wärmeableitungssystem nach einem der Ansprüche 1 bis 2, das ferner eine Kühlvorrichtung (16) oder eine Wasserkältemaschine umfasst, die außerhalb des Kühlbeckens (11) angeordnet ist, wobei der Wärmetauscher (12) mit der Kühlvorrichtung (16) oder der Wasserkältemaschine unter Verwendung eines Rohrs verbunden ist und das Wärmetauschmedium in dem Wärmetauscher (12) aus dem Wärmetauscher (12) heraus fließt, Kühlen durch die Kühlvorrichtung (16) oder die Wasserkältemaschine unterzogen wird, und dann zurück fließt.

4. Elektronische Vorrichtung (14), wobei die elektronische Vorrichtung mit dem Wärmeableitungssystem nach einem der Ansprüche 1 bis 3 angeordnet ist.

## Revendications

1. Système de dissipation de chaleur d'un dispositif électronique (14), comportant un bassin (11) de refroidissement, un échangeur (12) de chaleur, et au moins une pompe (13) de circulation :
un milieu (111) de refroidissement étant placé dans le bassin (11) de refroidissement, et le dispositif électronique (14) et l'échangeur (12) de chaleur étant immergés dans le milieu (111) de refroidissement ;
la pompe (13) de circulation étant configurée pour entraîner le milieu (111) de refroidissement à s'écouler de façon circulatoire entre le dispositif électronique (14) et l'échangeur (12) de chaleur ; et
un milieu d'échange de chaleur étant placé dans l'échangeur (12) de chaleur et utilisé pour échanger de la chaleur avec le milieu (111) de refroidissement, et le milieu d'échange de chaleur s'écoulant hors de l'échangeur (12) de chaleur pour le refroidissement puis revenant ;
une plaque entretoise (15), configurée pour diviser le bassin (11) de refroidissement en deux chenaux, le milieu (111) de refroidissement s'écoulant du dispositif électronique (14) à l'échangeur (12) de chaleur dans l'un des chenaux, et s'écoulant de l'échangeur (12) de chaleur au dispositif électronique (14) dans l'autre chenal
**caractérisé en ce que**
l'échangeur (12) de chaleur est un échangeur de chaleur liquide-liquide.

2. Système de dissipation de chaleur selon la revendication 1 :
l'échangeur (12) de chaleur étant disposé sur un côté du bassin (11) de refroidissement.

3. Système de dissipation de chaleur selon l'une quelconque des revendications 1 à 2, comportant en outre un appareil (16) de refroidissement ou une machine frigorifique à eau disposés à l'extérieur du bassin (11) de refroidissement, l'échangeur (12) de chaleur étant relié à l'appareil (16) de refroidissement ou à la machine frigorifique à eau en utilisant un tuyau, et le milieu d'échange de chaleur dans l'échangeur (12) de chaleur s'écoulant hors de l'échangeur (12) de chaleur, subissant un refroidissement par l'appareil (16) de refroidissement ou la machine frigorifique à eau, puis revenant.

4. Dispositif électronique (14). le dispositif électronique étant muni du système de dissipation de chaleur selon l'une quelconque des revendications 1 à 3.
